# FASCICULE DE BREVET EUROPEEN

(11) **EP 4 055 319 B1**
(45) Date de publication et mention de la délivrance du brevet: **16.08.2023**
(21) Numéro de dépôt: 20789172.2
(22) Date de dépôt: 14.10.2020
(51) Int. Cl.: F21S 41/153, F21S 45/47, H01L 25/075, H01L 33/50, H05K 1/02, H05K 1/18, H01L 25/16, H01L 33/62, H01L 33/64

(54) **ENSEMBLE DE SOURCES LUMINEUSES, DISPOSITIF D'ÉCLAIRAGE AUTOMOBILE LE COMPRENANT, ET PROCÉDÉ DE FABRICATION D'UN TEL ENSEMBLE**
LICHTQUELLENANORDNUNG, KRAFTFAHRZEUGBELEUCHTUNGSVORRICHTUNG DAMIT, UND VERFAHREN ZUR HERSTELLUNG EINER SOLCHEN ANORDNUNG
LIGHT SOURCE ASSEMBLY, AUTOMOTIVE LIGHTING DEVICE COMPRISING THE SAME, AND METHOD OF MANUFACTURING SUCH AN ASSEMBLY

(30) Priorité: 06.11.2019 FR 1912436
(43) Date de publication de la demande: 14.09.2022
(73) Titulaire: Valeo Vision, 93012 Bobigny Cedex (FR)
(72) Inventeur: VAL, Alexandre, 93012 BOBIGNY Cedex (FR); ALILI, Amine, 93012 BOBIGNY Cedex (FR); BELKESSAM, Samya, 93012 BOBIGNY Cedex (FR)
(74) Mandataire: Valeo Visibility
(86) Numéro de dépôt international: PCT/EP2020/078975
(87) Numéro de publication internationale: WO 2021/089286

(56) Documents cités:
- EP-A1- 3 203 138
- US-A1- 2008 291 688
- KUISMA HEIKKI ET AL: "FO-WLP multi-DOF inertial sensor for automotive applications", 2018 7TH ELECTRONIC SYSTEM-INTEGRATION TECHNOLOGY CONFERENCE (ESTC), IEEE, 18 septembre 2018 (2018-09-18), pages 1-7, XP033452956, DOI: 10.1109/ESTC.2018.8546447
- LAU JOHN H: "Patent issues of embedded fan-out wafer/panel level packaging", 2016 CHINA SEMICONDUCTOR TECHNOLOGY INTERNATIONAL CONFERENCE (CSTIC), IEEE, 13 mars 2016 (2016-03-13), pages 1-7, XP032897593, DOI: 10.1109/CSTIC.2016.7463959

## Description

Cette invention est liée au domaine de la fabrication des dispositifs d'éclairage automobile et aux procédés qui s'y rapportent.

Les constructeurs automobiles haut de gamme utilisent de plus en plus les matrices de diodes électroluminescentes (DELs, également connues sous leur acronyme LEDs, pour: "light-emitting diodes" en langue anglaise) pour réaliser les fonctionnalités d'éclairage du véhicule automobile. Ces arrangements sont obtenus par des processus complexes ou par l'agencement de modules optiques qui hébergent plusieurs LEDs montées sur un dissipateur thermique en tant que dispositifs individuels, ou disposées dans une matrice de dispositifs à LED unique. Chaque LED individuelle est alimentée par un pilote dédié qui comprend une interface avec un microcontrôleur pour gérer la dynamique du faisceau lumineux par des routines logicielles. Cette approche peut être utilisée pour des dizaines de faisceaux lumineux mais, comme les exigences de résolution sont de plus en plus élevées, cette disposition ne peut pas être appliquée pour des sources lumineuses à forte pixellisation (comme celles comprenant des milliers de sources lumineuses) sous les contraintes automobiles de flexibilité de conception, de fabrication et de coût.

En conséquence, les dispositifs à LEDs pour l'automobile sont beaucoup plus conservateurs que dans le reste des applications d'éclairage. EP 3 203 138 A1 de l'arrière-plan technologique divulgue un dispositif d'éclairage pour véhicule automobile comprenant notamment: un substrat diélectrique avec des pistes conductrices, une pluralité de LEDs montées sur ledit substrat afin d'être connectées auxdites pistes et étant recouvertes par une couche d'un luminophore, au moins un circuit de pilotage pour piloter lesdites LEDs, un circuit intermédiaire pour connecter électriquement lesdites LEDs audit circuit de pilotage, et avantageusement un circuit de dissipation thermique.

US 2011/127912 A1 montre également l'importance de la dissipation de la chaleur dans la fabrication d'une matrice de LEDs pour un véhicule automobile. Toutefois, cette méthode présente des limites quant au nombre de LEDs pouvant être incluses dans un seul dispositif d'éclairage.

Une solution à ce problème est recherchée.

L'invention apporte une solution à ce problème au moyen d'un ensemble de sources lumineuses selon la revendication 1, d'un dispositif d'éclairage automobile selon la revendication 13 et d'un procédé de fabrication de l'ensemble de sources lumineuses selon la revendication 14. Les modes de réalisation préférés de l'invention sont définis dans des revendications dépendantes.

Sauf définition contraire, tous les termes (y compris les termes techniques et scientifiques) utilisés dans le présent document doivent être interprétés conformément aux usages de la profession. Il est également entendu que les termes d'usage courant doivent être interprétés comme étant usuels dans l'art concerné et non dans un sens idéalisé ou trop formel, à moins qu'ils ne soient expressément définis comme tels dans le présent document.

Dans ce texte, le terme "comprend" et ses dérivés (tels que "comprenant", etc.) ne doivent pas être compris dans un sens excluant, c'est-à-dire que ces termes ne doivent pas être interprétés comme excluant la possibilité que ce qui est décrit et défini puisse inclure d'autres éléments, étapes, etc.

Dans un premier aspect inventif, l'invention fournit un ensemble de sources lumineuses pour un dispositif d'éclairage automobile, l'ensemble comprenant :
- un circuit intégré ayant un premier côté et un deuxième côté opposé au premier côté, comprenant en outre un plot de connexion dans le premier côté ;
- une partie émettrice de lumière comprenant une pluralité de micro-sources lumineuses à semi-conducteurs connectées électriquement au premier côté du circuit intégré et une surface active disposée de manière à modifier la longueur d'onde des micro-sources lumineuses à semi-conducteurs ;
- un encapsulage fan-out, entourant au moins une partie du circuit intégré ;
- une première couche métallique multicouche disposée de manière à couvrir au moins une partie du premier côté du circuit intégré, assurant une connexion électrique entre le plot de connexion du circuit intégré et un plot de connexion de l'ensemble ;
- une deuxième couche métallique qui comprend des portions de contact qui sont en contact direct avec le deuxième côté du circuit intégré ;
- un élément de dissipation de la chaleur ;
- une couche de fixation de matrice disposée entre la deuxième couche métallique et l'élément de dissipation de la chaleur ; et
- une carte de circuit imprimé.

Cet ensemble de sources lumineuses répond aux problèmes thermiques dus à la présence d'un grand nombre de micro-LEDs.

De plus, la présence d'une couche métallique de chaque côté du circuit intégré est également destinée à contrôler la déformation. Ainsi, le processus de fabrication est amélioré.

Le terme "semi-conducteur" fait référence à la lumière émise par l'électroluminescence à l'état solide, qui utilise des semi-conducteurs pour convertir l'électricité en lumière. Par rapport à l'éclairage à incandescence, l'éclairage à l'état solide crée de la lumière visible avec une production de chaleur réduite et une dissipation d'énergie moindre. La masse généralement faible d'un dispositif d'éclairage électronique à l'état solide offre une plus grande résistance aux chocs et aux vibrations que les tubes/ampoules en verre cassant et les longs fils à filaments fins. Ils éliminent également l'évaporation des filaments, ce qui peut augmenter la durée de vie du dispositif d'éclairage. Certains exemples de ces types d'éclairage comprennent les diodes électroluminescentes (LEDs) à semi-conducteurs, les diodes électroluminescentes organiques (OLEDs) ou les diodes électroluminescentes à polymère (PLEDs) comme sources d'éclairage plutôt que les filaments électriques, le plasma ou le gaz.

L"'élément de dissipation de la chaleur" peut être un dissipateur thermique, une plaque de base, un caloduc ou d'autres diffuseurs thermiques appropriés.

En particulier, la deuxième couche métallique comprend du cuivre et une finition de nickel, de palladium et d'or.

Dans l'environnement automobile, aucune connexion en cuivre nu ne peut être exposée à l'environnement, c'est pourquoi ce type de finition est utilisé.

Dans certains modèles, la surface active est disposée selon un plan parallèle aux premier et deuxième côtés du circuit intégré.

La coplanarité des plots (anode et cathode) du premier côté du circuit intégré est contrôlée afin de s'assurer que les milliers de connexions sont effectuées avec précision.

Dans certaines réalisations particulières, la deuxième couche métallique est parallèle à la surface active.

Cette condition facilite le processus de fabrication.

Dans certaines réalisations particulières, la distance entre le plot de l'ensemble et la surface active est comprise entre 2 mm et 4 mm.

Cette distance réduite contribue à simplifier le système de masquage qui est placé au-dessus pour éviter toute lumière directement incidente, comme celles dues à la réflexion optique provenant du fil ou du ruban.

Dans certaines réalisations, le deuxième côté du circuit intégré est partiellement recouvert par l'encapsulation fan-out, et la deuxième couche métallique comprend des saillies métalliques qui traversent l'encapsulation fan-out pour entrer en contact avec le deuxième côté du circuit intégré.

Cette disposition offre une bonne résistance thermique et, en même temps, une protection dorsale pour le circuit intégré. Cela est également avantageux pour obtenir une bonne adhérence de la deuxième couche métallique sur la couche d'attache de la matrice. Dans ces cas, une couche d'attache, telle que la pulvérisation métallique, est généralement réalisée.

Dans certaines réalisations particulières, le premier multicouche métallique comprend au moins une couche de redistribution.

Actuellement, les connexions d'alimentation électrique sont généralement capables de transmettre 5 à 10 A, ce qui correspond à une couche de redistribution en cuivre de 5 à 10 µm d'épaisseur. Le schéma de la couche de redistribution est conçu selon le principe de la plus courte distance, de manière à minimiser le nombre de vias. En fait, les vias ont généralement un diamètre d'environ 80 µm pour pouvoir transmettre 5 à 10 A.

Dans certaines réalisations particulières, la couche de redistribution est disposée autour de la partie émettrice de lumière.

Cela permet d'assurer une protection mécanique et de contribuer à la dissipation de la chaleur.

Dans certaines réalisations particulières, la première multicouche métallique comprend en outre un fil ruban qui relie le plot de l'ensemble à la carte de circuit imprimé.

Dans d'autres cas, une connexion alternative est utilisée, comme un fil d'aluminium, de cuivre ou d'or ou une pince en cuivre, qui peuvent être mélangés pour gérer les connexions de puissance et de signal. Toutefois, si un fil ruban est utilisé, il n'est pas nécessaire de protéger les fils avec de la résine supplémentaire.

Dans certains cas particuliers, la première multicouche métallique comprend un via qui traverse l'encapsulage fan-out qui relie le plot du circuit intégré au plot de l'ensemble.

Cette connexion conductrice est généralement réalisée par l'ajout d'un circuit imprimé à quatre couches ou d'un intercalaire en céramique, ou par le perçage direct d'un trou traversant en polymère, afin d'établir une connexion électrique entre la plage de connexion du pilote et la borne de l'ensemble, qui se trouve dans ce cas sur la deuxième face de l'appareil.

Dans certains cas particuliers, la couche de fixation de la matrice est constituée d'au moins une colle de silicone, d'un alliage de soudure, d'une colle de frittage d'argent ou de charges métalliques.

Dans le cas où cet ensemble est utilisé avec une configuration de montage secondaire, les principales fonctions de la couche de fixation de la matrice sont de transférer l'énergie thermique avec la plus faible résistance possible, d'assurer une fixation mécanique et de garantir une fiabilité. Comme il n'y a pas de fonction électrique, on peut choisir une colle au silicium ou un alliage de soudure avec des charges métalliques.

Dans le cas où cet ensemble est utilisé avec une configuration CMS (acronyme pour: connexion définie par un masque de soudure), un alliage de soudure ou une colle de frittage à l'argent doit être utilisé, car, dans ce cas, cette couche remplit également la fonction de fournir une connexion électrique.

Dans certains cas particuliers, la couche active est un revêtement de phosphore comprenant un matériau à base de silicone et des particules métalliques.

Comme la couche active est une zone critique pour la propagation des coups de soleil, il est très avantageux que la surface ait une conductivité thermique supérieure à 50 W/m/°C. Un tel revêtement de phosphore permet d'utiliser des couches de redistribution en cuivre et une finition.

Dans un deuxième aspect inventif, l'invention fournit un dispositif d'éclairage automobile comprenant une pluralité d'ensembles de sources lumineuses selon le premier aspect inventif.

Dans un troisième aspect inventif, l'invention fournit une méthode de fabrication d'un ensemble de sources lumineuses selon le premier aspect inventif, la méthode comprenant les étapes suivantes
- fournir un support de circuit intégré initial ;
- sélectionner des portions du support de circuit intégré d'origine qui conviennent à la fabrication d'un ensemble de sources lumineuses ;
- placer sur des portions appropriées un ruban adhésif pour former un support reconstruit ;
- placer des interposeurs pour le branchement électrique ;
- sélectionner les portions du support reconstruit appropriées pour un encapsulage ;
- effectuer le meulage de la face arrière du support reconstruit pour définir l'épaisseur ou pour exposer la face arrière en silicium ;
- ajouter une première couche métallique multicouche sur une première face du support reconstruit pour créer une connexion entre chaque plot de circuit intégré et chaque plot de l'ensemble ;
- ajouter une deuxième couche métallique sur une deuxième face du support reconstruit ;
- fixer une pluralité de micro-sources lumineuses à semi-conducteurs ;
- singulariser le support reconstruit.

L'utilisation d'un support reconstruit permet d'appliquer une méthode où 100 % du support est connue pour être acceptable, de sorte que le support entier peut être peuplé de matrices de DELs. Cela permet d'améliorer le rendement et de mieux contrôler la déformation. En outre, les six côtés du circuit intégré sont protégés des conditions environnementales, puisque l'encapsulation et les première et deuxième couches métalliques assurent la protection et le contrôle de la déformation.

La mise en place des couches de redistribution à un stade précoce du processus, indépendamment de la connexion finale de l'ensemble, en tant que sous-ensemble ou CMS, rend le processus plus facile et moins coûteux, puisque le rendement est amélioré, et l'assemblage final des éléments de dissipation de la chaleur est également amélioré.

Dans certaines réalisations particulières, après l'étape de fixation des micro-sources lumineuses à semi-conducteurs, la méthode comprend en outre au moins une des étapes suivantes
- processus de refusion après la fixation de micro-sources lumineuses à l'état solide
- le dépôt de sous-remplissage entre les micro-sources lumineuses à semi-conducteurs et le support reconstruit ;
- effectuer des traitements sur les micro-sources lumineuses à l'état solide, tels qu'un traitement de surface ou un traitement d'amincissement ; et/ou
- effectuer des tests opto-électriques.

Ces étapes supplémentaires facultatives permettent de fournir un ensemble optimisé pour un dispositif d'éclairage automobile.

Pour compléter la description et pour permettre une meilleure compréhension de l'invention, un ensemble de dessins est fourni. Ces dessins font partie intégrante de la description et illustrent des modes de réalisation de l'invention, qui ne doivent pas être interprétés comme limitant la portée de l'invention, mais simplement comme des exemples de la manière dont l'invention peut être réalisée. Les dessins comprennent les figures suivantes :
[Fig. 1] montre une approche générale d'un premier mode de réalisation d'un ensemble de sources lumineuses selon l'invention.
[Fig. 2] montre une approche générale d'un autre mode de réalisation d'un ensemble de sources lumineuses selon l'invention.
[Fig. 3] montre un détail des couches de redistribution d'un mode de réalisation d'un ensemble de sources lumineuses selon l'invention.
[Fig. 4] montre un détail des saillies de contact entre deux couches d'un ensemble de sources lumineuses selon l'invention.
[Fig. 5a] à [Fig. 5c] montrent les étapes d'une méthode de fabrication selon l'invention.

Les éléments des exemples de réalisation sont systématiquement désignés par les mêmes chiffres de référence dans tous les dessins et une description détaillée le cas échéant :
- 1: Ensemble de sources lumineuses
- 2: Circuit intégré
- 21: Premier côté du circuit intégré
- 22: Second côté du circuit intégré
- 23: plot du circuit intégré
- 24: Anode
- 25: Cathode
- 3: Micro-LED
- 31: Plot micro-LED
- 4: Surface active
- 5: Encapsulation fan-out
- 6: Première couche métallique multicouche
- 61: Couches de redistribution
- 62: Fil de fer
- 63: Via traversant en polymère
- 64: Couche de passivation
- 7: Plot de connexion
- 71: Première couche de polymère
- 72: Deuxième couche de polymère
- 73: Troisième couche de polymère
- 8: Seconde couche métallique
- 81: Portions de contact de la deuxième couche métallique
- 9: Couche d'attache
- 10: Dispositif d'éclairage pour automobile
- 11: Dissipateur de chaleur
- 12: Circuit imprimé
- 13: Couche thermique intermédiaire
- 101: Support initial
- 102: Portions appropriées
- 103: Support reconstruit

Les exemples de réalisation sont décrits de manière suffisamment détaillée pour permettre à ceux qui ont des compétences ordinaires dans cet art de réaliser et de mettre en oeuvre les systèmes et les processus décrits ici. Il est important de comprendre que ces exemples peuvent être fournis sous de nombreuses formes différentes et ne doivent pas être considérés comme se limitant aux exemples présentés ici.

En conséquence, bien que la réalisation puisse être modifiée de diverses manières et prendre diverses formes alternatives, des réalisations spécifiques de celle-ci sont montrées dans les dessins et décrites en détail ci-dessous à titre d'exemple. Il n'y a aucune intention de se limiter aux formes particulières divulguées. Au contraire, toutes les modifications, équivalents et alternatives entrant dans le champ d'application des revendications annexées doivent être inclus. Les éléments des exemples de réalisations sont systématiquement désignés par les mêmes chiffres de référence dans les dessins et une description détaillée le cas échéant.

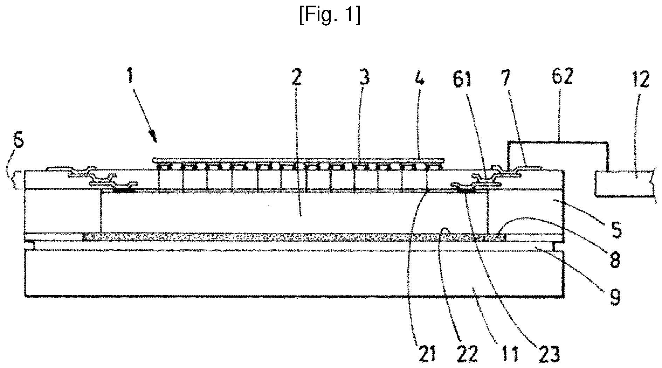

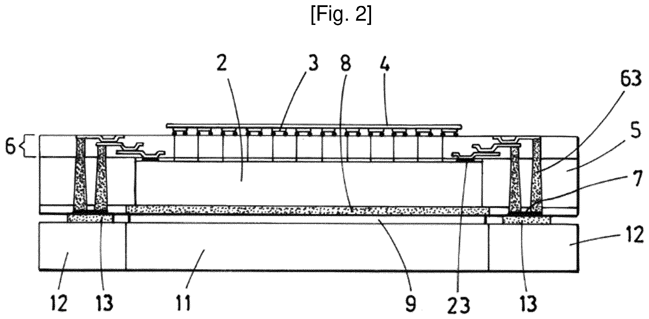

Les figures 1 et 2 montrent une approche générale de deux modes de réalisation d'un ensemble de sources lumineuses 1 selon l'invention. La figure 1 est orientée vers une connexion sous-monture, tandis que la figure 2 montre l'incorporation destinée à être connectée avec une connexion définie par un masque de soudure (CMS).

Les ensembles 1 illustrés aux figures 1 et 2 comprennent un circuit intégré 2, une partie émettrice de lumière avec des micro-LEDs 3 et une surface active 4, un encapsulage en éventail (dit: fan-out) 5, une première multicouche métallique 6, une deuxième couche métallique 8, une couche de fixation de puce 9, un dissipateur thermique 11 et une carte de circuit imprimé 12.

Le circuit intégré 2 est un circuit intégré ASIC avec un premier côté 21 et un second côté 22 opposé au premier côté 21 et comprend un plot 23 dans le premier côté 21.

La partie émettrice de lumière comprend une pluralité de micro-LEDs 3 qui sont électriquement connectées au premier côté 21 du circuit intégré 2, pour recevoir l'alimentation et la commande. La surface active 4 est disposée de manière à modifier la longueur d'onde des micro-LEDs 3, de sorte que l'émission lumineuse finale soit blanche, comme l'exigent les fonctionnalités automobiles.

L'encapsulation 5 fan-out est disposée de manière à entourer le circuit intégré 2. L'ensemble fan-out 5 est chargé de l'entourage latéral, mais le deuxième côté 22 du circuit intégré 2 est également protégé par une petite partie de l'ensemble fan-out 5.

Le premier multicouche métallique 6 est disposé de manière à couvrir une partie de la première face 21 du circuit intégré 2. Ce premier multicouche métallique 6 est différent dans chaque variante, il sera donc décrit plus en détail ultérieurement. Dans tous les cas, ce premier multicouche métallique 6 assure une connexion électrique entre le plot 23 du circuit intégré 2 et le plot 7 de l'ensemble.

La deuxième couche métallique 8 comprend des saillies métalliques 81 qui traversent l'encapsulage 5 du fan-out pour être en contact direct avec le deuxième côté 22 du circuit intégré 2. Cette deuxième couche métallique est en cuivre et possède une finition en nickel.

La couche d'attache de la matrice 9 est disposée entre la deuxième couche métallique 8 et le dissipateur thermique 11, et sa mission est différente pour chaque mode de réalisation

Comme on peut l'observer sur ces deux figures, la surface active 4 est disposée selon un plan, qui est parallèle aux premiers 21 et seconds 22 côtés du circuit intégré 2. Ce plan est également parallèle à la deuxième couche métallique 8. Cette disposition parallèle est plus facile à concevoir et à fabriquer, et offre également une bonne endurance structurelle, de sorte que ces petits plots sont capables de conserver leur forme malgré les charges thermiques et structurelles qu'ils subissent.

Au-dessus des micro-LEDs 3, la couche active 4 comprend un revêtement de phosphore qui est déposé par pulvérisation. Ce revêtement est un matériau à base de silicone rempli de particules métalliques pour donner une couleur blanche à la lumière projetée finale (puisque les LEDs émettent dans la longueur d'onde bleue). Dans certaines réalisations, ce revêtement peut également être étalé sur des couches de redistribution, pour jouer un rôle de protection et un rôle supplémentaire de libération du stress local. Cependant, cette couche n'atteint pas les plots de l'ensemble 7, car elle serait considérée comme une contamination pour ces éléments. La surface supplémentaire donnée par l'encapsulation fan-out 5 contribue à éviter une telle contamination.

La figure 1 montre une réalisation d'un ensemble de sources lumineuses 1 qui est particulièrement configuré pour être utilisé dans une connexion sous-marine. La structure du premier multicouche métallique est donc différente de celle de la figure 2.

Dans cette figure, le premier multicouche métallique comprend plusieurs couches de redistribution 61 qui assurent la connexion électrique entre le plot 23 du pilote 2 et le plot 7 de l'ensemble qui, dans cette réalisation, est situé sur la face supérieure de l'ensemble 1.

La distance minimale entre le plot 7 et la surface active 4 dépend du système optique choisi pour être placé au-dessus de l'ensemble de sources lumineuses, mais peut osciller entre 2 et 4 mm. Cette distance réduite contribue à simplifier le système de masquage qui est placé au-dessus afin d'éviter toute lumière directement incidente, comme celles dues à la réflexion optique provenant du fil ou du ruban 62.

Les problèmes thermiques sont également atténués par la position des couches de redistribution 61, autour de la partie émettrice de lumière.

La couche d'attache 9 de ce mode de réalisation est destinée à transférer l'énergie thermique avec la plus faible résistance possible. Une pâte d'alliage de soudure avec des charges métalliques est utilisée pour que la chaleur soit facilement dissipée vers le dissipateur 11. En outre, cette couche de fixation de puce 9 assure la fixation mécanique de l'ensemble de sources lumineuses 1 à la structure principale du dispositif d'éclairage, qui est représentée par le dissipateur thermique 11.

La figure 2 montre une autre réalisation d'un ensemble de sources lumineuses 1, qui est particulièrement configuré pour être utilisé dans une connexion définie par un masque de soudure (CMS). La structure du premier multicouche métallique est donc différente de celle de la figure 1.

Dans ce cas, le premier multicouche métallique 6 comprend une via 63 conductrice qui traverse l'encapsulage 5 du fan-out qui relie le plot du pilote 23 au plot de l'ensemble 7, qui dans ce cas est situé dans la partie inférieure de l' ensemble 1.

Dans ce cas, le plot de connexion 7 est relié à la carte de circuit imprimé 12 au moyen d'une couche de fixation 13. Comme cette couche de fixation 13 remplit une fonction électrique, un alliage de soudure est utilisé. Dans différentes réalisations, une colle conductrice d'électricité, avec ou sans frittage, peut être utilisée à cette fin.

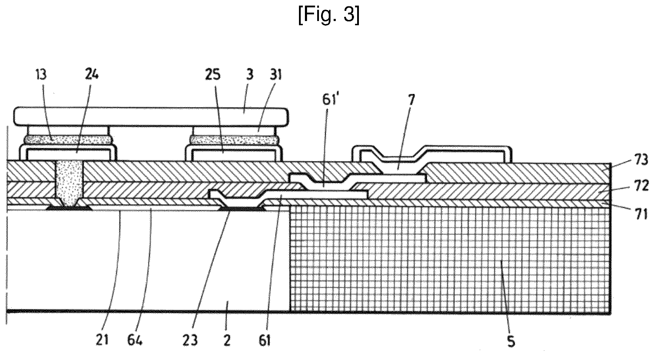

La figure 3 montre un détail des couches de redistribution d'un mode de réalisation d'un ensemble de sources lumineuses selon l'invention.

Le circuit intégré 2 comprend une couche de passivation 64 qui est déposée sur la première face 21 du circuit intégré. La couche de passivation n'est pas appliquée sur le plot 23 du pilote 2, qui reçoit la première couche de redistribution 61. Cette première couche de redistribution 61 est déposée sur une première couche de polymère 71, tandis qu'une deuxième couche de polymère 72 est déposée pardessus, laissant un espace pour la connexion d'une deuxième couche de redistribution 61'. Sur cette deuxième couche de redistribution 61', une troisième couche de polymère 73 est déposée, laissant un espace vide pour la troisième et dernière couche de redistribution. Cette troisième couche de redistribution fournit le plot de connexion 7 de l'ensemble qui est destiné à être connecté à la carte de circuit imprimé 12 au moyen d'un fil ruban 62, comme le montre la figure 1.

Les micro-LEDs 3 sont connectées aux anodes 24 et aux cathodes 25 du pilote, au moyen d'une pâte à souder 13 qui relie chaque anode et chaque cathode aux plots de connexion 31 des LEDs.

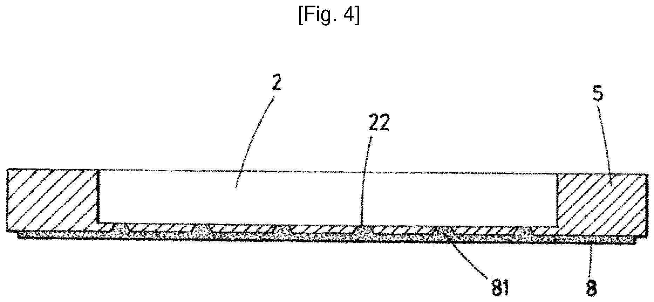

La figure 4 montre un détail des protubérances de contact entre deux couches d'un ensemble de sources lumineuses selon l'invention.

Dans cette réalisation, l'encapsulation 5 comprend une partie qui couvre le deuxième côté 22 du circuit intégré 2, et la deuxième couche métallique 8 comprend des saillies métalliques 81 qui traversent cette partie de l'encapsulation 5 pour être en contact direct avec le deuxième côté 22 du circuit intégré 2. Cette deuxième couche métallique 8 est en cuivre et possède une finition en nickel.

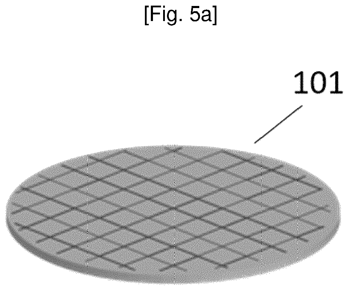

Les figures 5a à 5c montrent les étapes d'une méthode de fabrication selon l'invention.

La figure 5a montre la fourniture d'un support 101 initial, où est conçu le circuit intégré du futur ensemble.

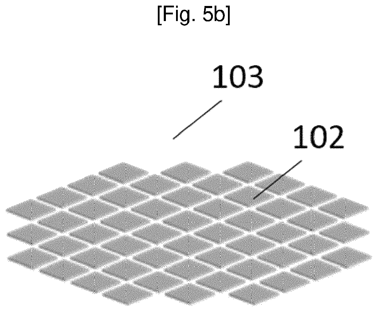

Cette gaufrette originale est testée pour repérer les portions connues de la bonne pâte. Ensuite, la galette originale est découpée en dés et, selon la figure 5b, les portions de bonne-mort 102 sont disposées sur un ruban, formant une galette reconstruite 103.

Sur ce support 103 reconstruit, différents éléments sont ajoutés pour former un ensemble électronique complet. Tout d'abord, des interposeurs sont ajoutés, afin d'assurer une connexion électrique entre les parties en bon état et le futur substrat où l'ensemble sera connecté.

Ensuite, la surface du support reconstruit reçoit un encapsulage, pour fixer chaque partie du support et pour manipuler le support reconstruit comme une seule pièce. Le support reconstruit est ensuite rectifié pour exposer le silicium des portions de bonne maturation, afin que les couches métalliques puissent être ajoutées. Ces couches métalliques permettent de contrôler la déformation et d'assurer les connexions électriques entre les bornes du circuit intégré et les bornes de l'ensemble. Une fois ces couches ajoutées, le support reconstruit est prêt à recevoir la population de DELs.

La mise en place des couches de redistribution à un stade précoce du processus, indépendamment de la connexion finale de l'ensemble, en tant que sous-ensemble ou CMS, rend le processus plus facile et moins coûteux, puisque le rendement est amélioré, et l'assemblage final des éléments de dissipation de la chaleur est également amélioré.

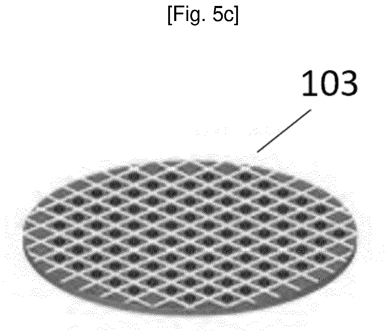

La figure 5c montre le résultat final du support 103 reconstruit après avoir subi les étapes précédentes. Tous les éléments électroniques nécessaires sont disposés de manière à former un ensemble de sources lumineuses selon l'invention.

Une fois que les LEDs sont disposées dans le support reconstruit, un processus de refusion a lieu, suivi d'un dépôt de sous-remplissage entre les micro-LEDs et les parties conductrices. Ensuite, la matrice de micro-LEDs est traitée et prête à être testée et isolée.

## Revendications

1. Ensemble de sources lumineuses (1) pour un dispositif d'éclairage automobile (10), l'ensemble comprenant :
- un circuit intégré (2) avec un premier côté (21) et un deuxième côté (22) opposé au premier côté (21), comprenant en outre un plot de connexion (23) dans le premier côté (21) ;
- une partie émettrice de lumière comprenant une pluralité de micro-sources lumineuses à semi-conducteurs (3) connectées électriquement au premier côté (21) du circuit intégré (2) et une surface active (4) agencée pour modifier la longueur d'onde des micro-sources lumineuses à semi-conducteurs (3) ;
- un encapsulage fan-out (5), entourant au moins une partie du circuit intégré (2) ;
- une première couche métallique multicouche (6) disposée de manière à couvrir au moins une partie du premier côté (21) du circuit intégré (2), assurant une connexion électrique entre le plot de connexion (23) du circuit intégré (2) et un plot de connexion (7) de l'ensemble ;
- une deuxième couche métallique (8) qui comprend des portions de contact (81) qui sont en contact direct avec le deuxième côté (22) du circuit intégré (2) ;
- un élément de dissipation de la chaleur (11) ;
- une couche de fixation de matrice (9) disposée entre la deuxième couche métallique (8) et l'élément de dissipation de la chaleur (11) ; et
- une carte de circuit imprimé (12).

2. Ensemble de sources lumineuses (1) selon la revendication 1, dans lequel la deuxième couche métallique (8) comprend du cuivre et une finition en nickel, palladium et or.

3. Ensemble de sources lumineuses (1) selon l'une des revendications précédentes, dans lequel la surface active (4) est disposée selon un plan, qui est parallèle aux premier (21) et deuxième (22) côtés du circuit intégré (2).

4. Ensemble de sources lumineuses (1) selon la revendication 3, dans lequel la deuxième couche métallique (8) est parallèle à la surface active (4).

5. Ensemble de sources lumineuses (1) selon l'une des revendications précédentes, dans lequel la distance entre le plot de l'ensemble (7) et la surface active (4) est comprise entre 2 mm et 4 mm.

6. Ensemble de sources lumineuses (1) selon l'une des revendications précédentes, dans lequel le second côté (22) du circuit intégré (2) est partiellement recouvert par l'encapsulation fan-out (5), et la seconde couche métallique (8) comprend des saillies métalliques (81) qui traversent l'encapsulation fan-out (5) pour entrer en contact avec le second côté (22) du circuit intégré (2).

7. Ensemble de sources lumineuses (1) selon l'une des revendications précédentes, dans lequel la première couche métallique multicouche (6) comprend au moins une couche de redistribution (61).

8. Ensemble de sources lumineuses (1) selon la revendication 7, dans lequel la couche de redistribution (61) est disposée autour de la partie émettrice de lumière.

9. Ensemble de sources lumineuses (1) selon l'une des revendications 7 ou 8, dans lequel la première couche métallique multicouche (6) comprend en outre un fil ruban (62) qui relie le plot de connexion (7) de l'ensemble à la carte de circuit imprimé (12).

10. Ensemble de sources lumineuses (1) selon l'une quelconque des revendications 1 à 5, dans lequel la première couche métallique multicouche (6) comprend un via (63) qui traverse l'encapsulation fan-out (5) et relie le plot de connexion (23) du circuit intégré au plot de connexion (7) de l'ensemble.

11. Ensemble de sources lumineuses (1) selon l'une des revendications précédentes, dans lequel la couche de fixation de la matrice (9) comprend au moins un élément parmi une colle silicone, un alliage de soudure, une colle de frittage à l'argent ou des charges métalliques.

12. Ensemble de sources lumineuses (1) selon l'une des revendications précédentes, dans lequel la couche active (4) est un revêtement de phosphore comprenant un matériau à base de silicone et des particules métalliques.

13. Dispositif d'éclairage automobile (10) comprenant une pluralité d'ensembles de sources lumineuses (1) selon l'une des revendications précédentes.

14. Procédé de fabrication d'un ensemble de sources lumineuses (1) selon l'une des revendications 1 à 12, le procédé comprenant les étapes suivantes
- fournir un support de circuit intégré initial (101) ;
- sélectionner des portions (102) du support de circuit intégré d'origine (101) qui conviennent à la fabrication d'un ensemble de sources lumineuses ;
- placer sur des portions appropriées un ruban adhésif pour former un support reconstruit (103) ;
- placer des interposeurs pour le branchement électrique ;
- sélectionner les portions (102) du support reconstruit (103) appropriées pour un encapsulage ;
- effectuer le meulage de la face arrière du support reconstruit (103) pour définir l'épaisseur ou pour exposer la face arrière en silicium ;
- ajouter une première couche métallique multicouche (6) sur une première face (21) du support reconstruit (103) pour créer une connexion entre chaque plot (23) de circuit intégré et chaque plot (7) de l'ensemble ;
- ajouter une deuxième couche métallique (8) sur une deuxième face (22) du support reconstruit (103);
- fixer une pluralité de micro-sources lumineuses à semi-conducteurs (3) ;
- singulariser le support reconstruit (103).

15. Procédé selon la revendication 14, dans lequel, après l'étape de fixation de micro-sources lumineuses à semi-conducteurs (3), le procédé comprend en outre au moins une des étapes suivantes
- processus de refusion après la fixation de micro-sources lumineuses à semi-conducteurs (3) ;
- dépôt de sous-remplissage entre les micro-sources lumineuses à semi-conducteurs (3) et le support reconstruit (103) ;
- effectuer des traitements sur les micro-sources lumineuses à semi-conducteurs (3), tels qu'un traitement de surface ou un traitement d'amincissement ; et/ou
- effectuer des tests opto-électriques.

## Patentansprüche

1. Lichtquelleneinheit (1) für eine Kraftfahrzeugbeleuchtungsvorrichtung (10), wobei die Einheit enthält:
- einen integrierten Schaltkreis (2) mit einer ersten Seite (21) und einer der ersten Seite (21) gegenüberliegenden zweiten Seite (22), der außerdem einen Anschlusskontakt (23) in der ersten Seite (21) enthält;
- einen lichtemittierenden Teil, der eine Vielzahl von Mikro-Halbleiterlichtquellen (3), die elektrisch mit der ersten Seite (21) des integrierten Schaltkreises (2) verbunden sind, und eine aktive Fläche (4) enthält, die eingerichtet ist, die Wellenlänge der Mikro-Halbleiterlichtquellen (3) zu verändern;
- eine Fan-Out-Verkapselung (5), die mindestens einen Teil des integrierten Schaltkreises (2) umgibt;
- eine erste mehrlagige Metallschicht (6), die so angeordnet ist, dass sie zumindest einen Teil der ersten Seite (21) des integrierten Schaltkreises (2) bedeckt, die eine elektrische Verbindung zwischen dem Anschlusskontakt (23) des integrierten Schaltkreises (2) und einem Anschlusskontakt (7) der Einheit gewährleistet;
- eine zweite Metallschicht (8), die Kontaktabschnitte (81) enthält, die mit der zweiten Seite (22) des integrierten Schaltkreises (2) in direktem Kontakt sind;
- ein Wärmeableitungselement (11);
- eine Matrixbefestigungsschicht (9), die zwischen der zweiten Metallschicht (8) und dem Wärmeableitungselement (11) angeordnet ist; und
- eine Leiterplatte (12).

2. Lichtquelleneinheit (1) nach Anspruch 1, wobei die zweite Metallschicht (8) Kupfer und eine Deckschicht aus Nickel, Palladium und Gold enthält.

3. Lichtquelleneinheit (1) nach einem der vorhergehenden Ansprüche, wobei die aktive Fläche (4) gemäß einer Ebene angeordnet ist, die parallel zu den ersten (21) und zweiten (22) Seiten des integrierten Schaltkreises (2) ist.

4. Lichtquelleneinheit (1) nach Anspruch 3, wobei die zweite Metallschicht (8) parallel zur aktiven Fläche (4) ist.

5. Lichtquelleneinheit (1) nach einem der vorhergehenden Ansprüche, wobei der Abstand zwischen dem Anschluss der Einheit (7) und der aktiven Fläche (4) zwischen 2 mm und 4 mm liegt.

6. Lichtquelleneinheit (1) nach einem der vorhergehenden Ansprüche, wobei die zweite Seite (22) des integrierten Schaltkreises (2) teilweise von der Fan-Out-Verkapselung (5) bedeckt wird, und die zweite Metallschicht (8) metallische Vorsprünge (81) enthält, die die Fan-Out-Verkapselung (5) durchqueren, um mit der zweiten Seite (22) des integrierten Schaltkreises (2) in Kontakt zu kommen.

7. Lichtquelleneinheit (1) nach einem der vorhergehenden Ansprüche, wobei die erste mehrlagige Metallschicht (6) mindestens eine Umverteilungsschicht (61) enthält.

8. Lichtquelleneinheit (1) nach Anspruch 7, wobei die Umverteilungsschicht (61) um den lichtemittierenden Teil herum angeordnet ist.

9. Lichtquelleneinheit (1) nach einem der Ansprüche 7 oder 8, wobei die erste mehrlagige Metallschicht (6) außerdem einen Banddraht (62) enthält, der den Anschlusskontakt (7) der Einheit mit der Leiterplatte (12) verbindet.

10. Lichtquelleneinheit (1) nach einem der Ansprüche 1 bis 5, wobei die erste mehrlagige Metallschicht (6) eine Durchkontaktierung (63) enthält, die die Fan-Out-Verkapselung (5) durchquert und den Anschlusskontakt (23) des integrierten Schaltkreises mit dem Anschlusskontakt (7) der Einheit verbindet.

11. Lichtquelleneinheit (1) nach einem der vorhergehenden Ansprüche, wobei die Befestigungsschicht der Matrix (9) mindestens ein Element aus einem Silikonkleber, einer Schweißlegierung, einem Silbersinterkleber oder metallischen Füllstoffen enthält.

12. Lichtquelleneinheit (1) nach einem der vorhergehenden Ansprüche, wobei die aktive Schicht (4) ein Phosphorbelag ist, der ein Material auf Silikonbasis und metallische Teilchen enthält.

13. Kraftfahrzeugbeleuchtungsvorrichtung (10), die eine Vielzahl von Lichtquelleneinheiten (1) nach einem der vorhergehenden Ansprüche enthält.

14. Verfahren zur Herstellung einer Lichtquelleneinheit (1) nach einem der Ansprüche 1 bis 12, wobei das Verfahren die folgenden Schritte enthält
- Bereitstellung eines Ausgangsträgers des integrierten Schaltkreises (101);
- Auswahl von Abschnitten (102) des Ausgangsträgers des integrierten Schaltkreises (101), die für die Herstellung einer Lichtquelleneinheit geeignet sind;
- Anordnen eines Klebebands auf geeigneten Abschnitten, um einen neukonstruierten Träger (103) zu bilden;
- Anordnen von Interposern für den elektrischen Anschluss;
- Auswahl der für eine Verkapselung geeigneten Abschnitte (102) des neukonstruierten Trägers (103);
- Ausführen des Schleifens der Rückseite des neukonstruierten Trägers (103), um die Dicke zu definieren oder um die Rückseite aus Silicium zu belichten;
- Hinzufügen einer ersten mehrlagigen Metallschicht (6) auf eine erste Seite (21) des neukonstruierten Trägers (103), um eine Verbindung zwischen jedem Anschluss (23) des integrierten Schaltkreises und jedem Anschluss (7) der Einheit zu erzeugen;
- Hinzufügen einer zweiten Metallschicht (8) auf eine zweite Seite (22) des neukonstruierten Trägers (103) ;
- Befestigen einer Vielzahl von Mikro-Halbleiterlichtquellen (3);
- Individualisieren des neukonstruierten Trägers (103) .

15. Verfahren nach Anspruch 14, wobei, nach dem Schritt der Befestigung von Mikro-Halbleiterlichtquellen (3), das Verfahren außerdem mindestens einen der folgenden Schritte enthält
- Umschmelzprozess nach der Befestigung von Mikro-Halbleiterlichtquellen (3);
- Aufbringen einer Unterfüllung zwischen den Mikro-Halbleiterlichtquellen (3) und dem neukonstruierten Träger (103);
- Ausführen von Bearbeitungen auf den Mikro-Halbleiterlichtquellen (3), wie eine Oberflächenbearbeitung oder eine Verdünnungsbearbeitung; und/oder
- Ausführen von opto-elektrischen Tests.

## Claims

1. An assembly of light sources (1) for a motor vehicle lighting device (10), the assembly comprising:
- an integrated circuit (2) with a first side (21) and a second side (22) opposite the first side (21), further comprising a connection pad (23) in the first side (21);
- a light-emitting part comprising a plurality of micro semiconductor light sources (3) which are electrically connected to the first side (21) of the integrated circuit (2) and an active surface (4) arranged so as to modify the wavelength of the micro semiconductor light sources (3);
- a fan-out packaging (5), surrounding at least part of the integrated circuit (2);
- a first multilayer metal layer (6) arranged so as to cover at least part of the first side (21) of the integrated circuit (2), providing an electrical connection between the connection pad (23) of the integrated circuit (2) and a connection pad (7) of the assembly;
- a second metal layer (8) comprising contact portions (81) which are in direct contact with the second side (22) of the integrated circuit (2);
- a heat sink element (11);
- an array bonding layer (9) arranged between the second metal layer (8) and the heat sink element (11); and
- a printed circuit board (12).

2. The assembly of light sources (1) as claimed in claim 1, wherein the second metal layer (8) comprises copper and a finish made of nickel, palladium and gold.

3. The assembly of light sources (1) as claimed in one of the preceding claims, wherein the active surface (4) is arranged in a plane that is parallel to the first (21) and second (22) sides of the integrated circuit (2).

4. The assembly of light sources (1) as claimed in claim 3, wherein the second metal layer (8) is parallel to the active surface (4).

5. The assembly of light sources (1) as claimed in one of the preceding claims, wherein the distance between the pad of the assembly (7) and the active surface (4) is between 2 mm and 4 mm.

6. The assembly of light sources (1) as claimed in one of the preceding claims, wherein the second side (22) of the integrated circuit (2) is partially covered by the fan-out packaging (5), and the second metal layer (8) comprises metal projections (81) which pass through the fan-out packaging (5) to come into contact with the second side (22) of the integrated circuit (2).

7. The assembly of light sources (1) as claimed in one of the preceding claims, wherein the first multilayer metal layer (6) comprises at least one redistribution layer (61).

8. The assembly of light sources (1) as claimed in claim 7, wherein the redistribution layer (61) is arranged around the light-emitting portion.

9. The assembly of light sources (1) as claimed in one of claims 7 or 8, wherein the first multilayer metal layer (6) further comprises a ribbon cable (62) which connects the connection pad (7) of the assembly to the printed circuit board (12).

10. The assembly of light sources (1) as claimed in any one of claims 1 to 5, wherein the first multilayer metal layer (6) comprises a via (63) which passes through the fan-out packaging (5) and connects the pad connection (23) of the integrated circuit to the connection pad (7) of the assembly.

11. The assembly of light sources (1) as claimed in one of the preceding claims, wherein the array bonding layer (9) comprises at least one element from among a silicone adhesive, a solder alloy, a silver sinter paste or metal fillers.

12. The assembly of light sources (1) as claimed in one of the preceding claims, wherein the active layer (4) is a phosphor coating comprising a silicone-based material and metal particles.

13. A motor vehicle lighting device (10) comprising a plurality of assemblies of light sources (1) as claimed in one of the preceding claims.

14. A method for producing an assembly of light sources (1) as claimed in one of claims 1 to 12, the method comprising the following steps
- providing an initial integrated circuit carrier (101);
- selecting portions (102) of the starting integrated circuit carrier (101) that are suitable for the production of an assembly of light sources;
- placing on appropriate portions of an adhesive tape to form a reconstructed carrier (103);
- placing interposers for electrical connection;
- selecting the portions (102) of the reconstructed carrier (103) that are suitable for packaging;
- grinding the rear face of the reconstructed carrier (103) to define the thickness or to expose the silicon rear face;
- adding a first multilayer metal layer (6) to a first face (21) of the reconstructed carrier (103) to create a connection between each integrated circuit pad (23) and each assembly pad (7);
- adding a second metal layer (8) to a second face (22) of the reconstructed carrier (103);
- attaching a plurality of micro semiconductor light sources (3);
- dicing the reconstructed carrier (103).

15. The method as claimed in claim 14, wherein, after the step of attaching micro semiconductor light sources (3) , the method further comprises at least one of the following steps
- reflow process after attaching micro semiconductor light sources (3) ;
- underfill deposition between the micro semiconductor light sources (3) and the reconstructed carrier (103);
- performing treatments on the micro semiconductor light sources (3), such as a surface treatment or a thinning treatment; and/or
- performing opto-electrical tests.
